# EUROPÄISCHE PATENTANMELDUNG

(11) **EP 1 605 379 A1**
(43) Veröffentlichungstag der Anmeldung: **14.12.2005**
(21) Anmeldenummer: 05106305.5
(22) Anmeldetag: 21.11.2002
(51) Int. Cl.: G06F 17/50

(54) **Konstruktionsverfahren und CAD-System für Baugruppen**

(30) Priorität: 22.11.2001 DE 10157269
(62) Teilanmeldung aus: 02792599.9
(71) Anmelder: Koenig & Bauer Aktiengesellschaft, 97080 Würzburg (DE)
(72) Erfinder: Wander, Stefan, 97264 Helmstadt (DE)

(57) **Zusammenfassung**

Die Erfindung betrifft ein Verfahren zum Konstruieren einer aus mehreren Baugruppen zusammengesetzten Maschine mit folgenden Merkmalen:
- für mindestens einen zu konstruierenden Gegenstand wird zuerst ein den zu konstruierenden Gegenstand vereinfacht darstellendes Ersatz-Gestaltelement (EGEi) festgelegt,
- diesem Ersatz-Gestaltelement (EGEi) werden Informationen über die Geometrie des zu konstruierenden Gegenstandes zugeordnet,
- mittels des Ersatz-Gestaltelementes (EGEi) und/oder seinen zugeordneten Informationen wird ein näher detaillierter Gegenstand konstruiert.

## Beschreibung

Die Erfindung betrifft Konstruktionsverfahren und ein CAD-System gemäß dem Oberbegriff des Anspruchs 1, 36 und 44.

Herkömmliche CAD-Systeme umfassen ein oder mehrere Arbeitplätze mit wenigstens einem Eingabegerät zum Eingeben einer Gestaltbeschreibung des zu konstruierenden Gegenstandes und einer Anzeigeeinrichtung zum Anzeigen einer aus der Gestaltbeschreibung errechneten Darstellung des Gegenstandes. Ein Prozessor zum Errechnen der Darstellung des Gegenstandes aus der Gestaltbeschreibung kann einem einzelnen Arbeitsplatz oder mehreren Arbeitsplätzen gemeinsam zugeordnet sein.

Die Eingabe der Gestaltbeschreibung erfolgt schrittweise, indem ein Benutzer aus einer Mehrzahl von Gestaltelementen, die das CAD-System zur Auswahl anbietet und deren graphische Darstellung es beherrscht, mit Hilfe des Eingabegerätes eines auswählt und dessen Position und Orientierung in Bezug auf den zu konstruierenden Gegenstand, Größe und ggf. andere Parameter spezifiziert.

Diese Arbeitsweise herkömmlicher CAD-Systeme erfordert von einem Konstrukteur, der ein solches System nutzt, dass er seine Konstruktionsarbeit mit den kleinsten Elementen beginnt und komplexe Gegenstände Schritt für Schritt aus kleineren Einheiten zusammenfügt. Eine solche Arbeitsweise eignet sich schlecht für komplexe Konstruktionsaufgaben. Wenn eine aus einer Mehrzahl von Baugruppen zusammengesetzte Maschine konstruiert werden soll, so zwingt die oben beschriebene Arbeitsweise herkömmlicher CAD-Systeme dazu, zunächst die einzelnen Baugruppen im Detail zu konstruieren, bevor deren Konstruktionspläne zum Plan der Gesamtmaschine zusammengefügt werden können. Wenn sich bei diesem Zusammenfügen Schwierigkeiten ergeben, können zeit- und kostenaufwendige Konstruktionsänderungen in den einzelnen Baugruppen erforderlich werden. Darüber hinaus wird die Bearbeitung des Konstruktionsplanes der Gesamtmaschine mit einem solchen CAD-System äußerst zeitaufwendig, weil die Zahl der Gestaltelemente, die bei der Berechnung einer graphischen Darstellung berücksichtigt werden müssen, extrem groß ist.

Herkömmliche CAD-Systeme versuchen, diesem Mangel abzuhelfen, indem, wenn eine sehr detailreiche Darstellung des Konstruktionsgegenstandes angezeigt werden soll, diese durch sogenannte Facettierung vereinfacht wird. Dabei werden graphische Objekte, deren exakte graphische Darstellung auf einer Anzeigeeinrichtung hohen Rechenaufwand erfordert, wie z. B. stetig gekrümmte Kurven, Kreise, Ellipsen etc., in der Darstellung durch Polygonzüge ersetzt. Diese Lösung ist jedoch in manchen Fällen unbefriedigend, da es für einen Benutzer nicht ohne weiteres erkennbar ist, ob ein solcher Polygonzug innerhalb oder außerhalb der Grenzen eines Körpers liegt, den er darstellt, und somit eine sichere Angabe darüber, ob in dieser Weise vereinfacht dargestellte Maschinenteile in einer gewünschten Weise ineinander greifen oder voneinander sicher beabstandet sind, nicht möglich ist.

Ein weiterer Nachteil der Facettierung ist, dass dem in der graphischen Darstellung sichtbaren Polygonzug kein "reales" graphisches Objekt entspricht, das von einem Benutzer, z. B. durch Daraufzeigen mit einem Cursor in einer Bildschirmdarstellung, angewählt werden kann. Während viele CAD-Systeme für "reale", also nicht vereinfachte graphische Objekte Hilfsfunktionen wie etwa das Fällen eines Lots oder das Konstruieren einer Tangente an der Oberfläche des Objekts, eine Kontrolle auf Überlappung mit einem anderen Objekt, Abstandsberechnungen etc. unterstützen, sind diese Funktionen für einen durch Facettierung erhaltenen Polygonzug nicht verfügbar.

Wenn ein Konstrukteur aus diesen Gründen eine detaillierte Darstellung wählt, so muss er entsprechend lange Rechenzeiten für die Erzeugung der Darstellung in Kauf nehmen, selbst wenn er nur an einzelnen Details von ihr interessiert ist.

Die DE 199 59 617 A1 beschreibt ein Konstruktionssystem zum Konstruieren neuer Bauteile. Dabei wird eine vereinfachte Bauraumumgebung zur Verfügung gestellt, die den verfügbaren Raum für die Konstruktion der neuen Bauteile festlegt. Über die Gestalt des neu zu konstruierenden Bauteils wird keine Aussage getroffen, insbesondere ist kein vereinfachter Ersatzkörper des Bauteils vorhanden.

Die US 4 994 989 A und die DE 199 40 625 A1 werden aus komplizierten Gestaltelementen zur schnelleren Darstellung vereinfachte Ersatz-Gestaltelemente gebildet.

Der Erfindung liegt die Aufgabe zugrunde, ein CAD-System und Konstruktionsverfahren zu schaffen.

Die Aufgabe wird erfindungsgemäß durch die Merkmale des Anspruchs 1, 36 oder 44 gelöst.

Durch die bei diesem System gegebene Möglichkeit, beim Berechnen einer graphischen Darstellung des zu konstruierenden Gegenstandes Gruppen von Gestaltelementen wahlweise detailliert oder durch ein Ersatz-Gestaltelement darstellen zu lassen, lässt sich der Rechenaufwand zum Berechnen einer graphischen Darstellung deutlich reduzieren, ohne dass für einen speziell interessierenden Bereich des Gegenstandes Abstriche am Detailreichtum gemacht werden müssen, mit dem dieser Bereich dargestellt wird. Dies ermöglicht es zum Beispiel einem Konstrukteur, der eine einzelne Baugruppe einer zusammengesetzten Maschine entwirft, sich eine detaillierte Darstellung seiner Baugruppe im räumlichen Zusammenhang mit vereinfachten Darstellungen von Nachbarbaugruppen anzeigen zu lassen, um so z. B. einen schnellen Eindruck davon zu gewinnen, ob eine an der Konstruktion vorgenommene Änderung mit den geometrischen Eigenschaften benachbarter Baugruppen vereinbar ist.

Das System unterstützt vorzugsweise die Zuordnung von Gestaltelementen zu einer Gruppe durch einen Benutzer. Dies ermöglicht es einem Benutzer, eine Festlegung der Gruppenzugehörigkeit einzelner Gestaltelemente mit Rücksicht auf Zweck und Funktionsweise der zu konstruierenden Maschine zu treffen und so z. B. zusammenwirkende Gestaltelemente zu einer Gruppe zusammenzufügen. Dies sind Gesichtspunkte, die bei einer automatischen Zuordnung durch das System, z. B. nach dem Gesichtspunkt räumlicher Nähe, nicht ohne weiteres berücksichtigt werden können.

Um eine Gruppe zu bilden oder zu verändern, unterstützt das CAD-System die Zuordnung jedes einzelnen bereits eingegebenen Gestaltelementes zu einer Gruppe durch den Benutzer. Eine andere, am gleichen CAD-System realisierbare Möglichkeit, Gestaltelemente einer Gruppe zuzuordnen, ist das Öffnen der Gruppe durch einen Benutzer, mit der Folge, dass Gestaltelemente, die eingegeben werden, während die Gruppe offen ist, vom System automatisch der betreffenden Gruppe zugeordnet werden.

Auch die Zuweisung eines Ersatz-Gestaltelementes zu einer Gruppe ist zweckmäßigerweise durch einen Benutzer vornehmbar. Auf diese Weise ist es leicht möglich, dem Ersatz-Gestaltelement diejenigen Gestaltmerkmale zu verleihen, die für die Wechselwirkung einer durch das Ersatz-Gestaltelement repräsentierten Baugruppe mit benachbarten Baugruppen wesentlich sind. Dies erlaubt es einem Konstrukteur, der an einer ersten Baugruppe einer komplexen Maschine konstruiert, sich nur diese erste Baugruppe detailliert und benachbarte Baugruppen in Form ihres Ersatz-Gestaltelementes darstellen zu lassen, und so bei geringen Rechenzeiten für die Erzeugung einer Darstellung dennoch auch von den Nachbarbaugruppen diejenigen Details zu sehen, die für das Zusammenwirken mit der von ihm bearbeiteten ersten Baugruppe relevant sind.

Gemäß einer besonders bevorzugten Ausgestaltung unterstützt das CAD-System das Erzeugen von Gruppen durch einfaches Eingeben eines Ersatz-Gestaltelementes oder durch Erklären eines bereits eingegebenen Gestaltelementes zu einem Ersatz-Gestaltelement. Diese Eigenschaft erleichtert erheblich das Konstruieren im top-down-Verfahren und das arbeitsteilige Konstruieren. So genügt es nämlich, in einem ersten Arbeitsgang der Konstruktion, Ersatz-Gestaltelemente oder Gestaltelemente, die später zu Ersatz-Gestaltelementen umdefiniert werden, einzugeben, um so den Aufbau einer zu konstruierenden Maschine erst im Groben festzulegen, wobei ein Ersatz-Gestaltelement jeweils einer Baugruppe der Maschine entsprechen kann. Jedem dieser Ersatz-Gestaltelemente ist eine Gruppe von Gestaltelementen zugeordnet, die zum Zeitpunkt der Eingabe oder Definition des Ersatz-Gestaltelementes noch leer sein kann und die im Laufe der Konstruktion der dem Ersatz-Gestaltelement entsprechenden Baugruppe mit Gestaltelementen gefüllt wird. Dabei kann jedes der in die Gruppe eingegebenen Gestaltelemente wiederum ein Ersatz-Gestaltelement für eine Unterbaugruppe sein oder im laufe des Konstruktionsprozesses zu einem solchen definiert werden.

Die komplette Maschine kann so schon zu Beginn der Konstruktion aufgrund der Ersatz-Gestaltelemente in einem Grobaufbau komplett dargestellt werden. Es ist also nicht mehr erforderlich, dass alle Teile der Maschine exakt festgelegt sein müssen, um die räumliche Anordnung der kompletten Maschine darstellen zu können.

Das CAD-System eignet sich besonders zur Implementierung als ein System mit mehreren Arbeitsplätzen, wobei wenigstens einer der Arbeitsplätze einer der Gruppen derart zugeordnet ist, dass an diesem Arbeitsplatz das Hinzufügen, Verändern oder Entfernen von Gestaltelementen der Gruppe möglich ist, während dies an einem nicht dieser Gruppe zugeordneten Arbeitsplatz nicht möglich ist. Dies erlaubt es, die Konstruktion einer komplexen Maschine in eine Mehrzahl von Teilaufgaben aufzuteilen, von denen jede jeweils - aus der Perspektive des Konstrukteurs - einer Baugruppe der Maschine bzw. - aus der Perspektive des CAD-Systems - einem Ersatz-Gestaltelement entspricht. Ein mit dem Konstruieren der betreffenden Baugruppe beauftragter Mitarbeiter kann dann an seinem Arbeitsplatz verändernd auf die Gestaltelemente dieser Baugruppe zugreifen, während andere Mitarbeiter, die für andere Baugruppen zuständig sind, oder ein Konstruktionsleiter lediglich Lesezugriff auf diese Gruppe haben.

Ausführungsbeispiele der Erfindung sind in den Zeichnungen dargestellt und werden im folgenden näher beschrieben.

### Es zeigen:

- Fig. 1: eine schematische Darstellung eines Rechnernetzes, das ein CAD-System verkörpert;
- Fig. 2: eine schematische Darstellung einer Datenstruktur in einem Speicher des CAD-Systems;
- Fig. 3-5: die Entwicklung der Datenstruktur im Speicher im Laufe des Konstruktionsprozesses;
- Fig. 6: eine Blockdarstellung der im Laufe des Konstruktionsprozesses entstehenden Datenstruktur;
- Fig. 7: eine Variante der Datenstruktur von Fig. 6.
- Fig. 8-10: ein erstes Ausführungsbeispiel zur Variante der Datenstruktur von Fig. 7
- Fig. 11-13: ein zweites Ausführungsbeispiel zur Variante der Datenstruktur von Fig. 7

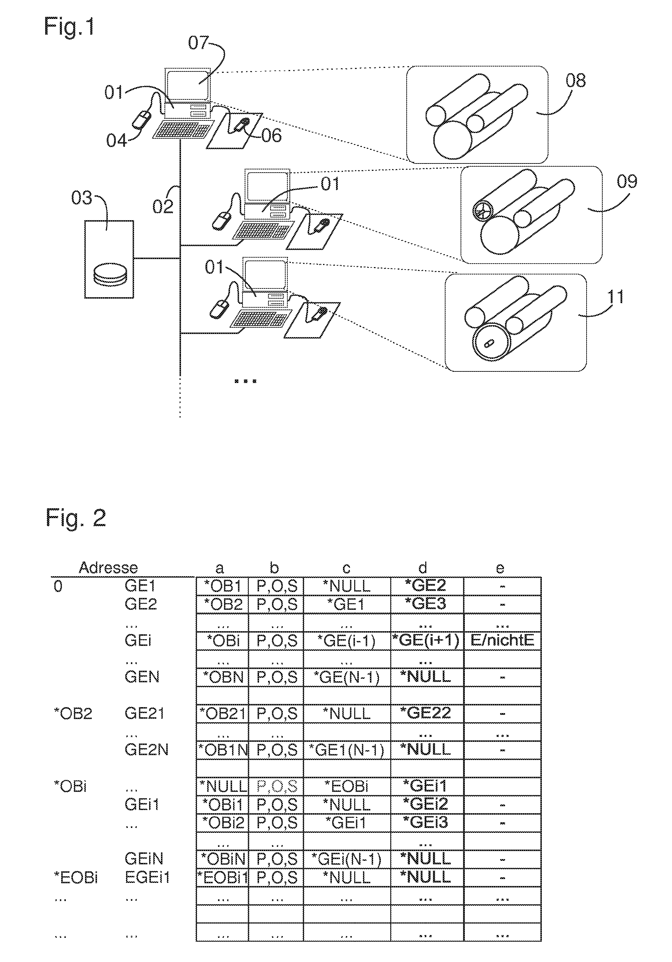

Das in Fig. 1 gezeigte Rechnernetz umfasst eine Mehrzahl von Arbeitsplatzrechnern 01, die jeweils mit einem eigenen Prozessor (nicht dargestellt) ausgestattet sind und über eine Netz-Datenleitung 02 von beliebiger Topologie auf einen gemeinsamen Speicher 03 zugreifen, der unter anderem Daten enthält, die einen an den Arbeitsplatzrechnern 01 zu konstruierenden Gegenstand beschreiben. Jeder Arbeitsplatzrechner 01 ist mit Eingabegeräten 04; 06 wie etwa einer Maus 04 oder einem Digitalisiertablett 06 ausgestattet, die eine zügige Eingabe von Koordinatenwerten ermöglichen. Jeder Arbeitsplatzrechner 01 umfasst ferner eine Anzeigeeinrichtung 07, z. B. einen Bildschirm 07 zum Anzeigen einer von dem Prozessor errechneten graphischen Darstellung eines komplexen Gegenstandes, der von einer Mehrzahl von Mitarbeitern an den einzelnen Arbeitsplatzrechnern 01 gemeinsam konstruiert wird, oder von Teilen desselben.

Die Konstruktionstätigkeit der einzelnen Mitarbeiter besteht im wesentlichen aus dem sukzessiven Eingeben von Objekten in den Arbeitsplatzrechner 01, die in Form von hier als Gestaltelement bezeichneten Datensätzen gespeichert werden und die jeweils eine Bezeichnung eines in die Konstruktion einzufügenden Objektes, Angaben über dessen Position und Orientierung in Bezug auf ein gegebenes Koordinatensystem und ggf. Skalierungsinformation umfassen.

Das Objekt eines Gestaltelementes kann elementar oder zusammengesetzt sein. Ein Objekt wird als elementar bezeichnet, wenn das CAD-System über ein Unterprogramm zum Berechnen einer graphischen Darstellung des Objekts verfügt. Einfache Objekte können z. B. Geraden, Rechtecke, Ellipsen, bzw. bei dreidimensionalem Konstruieren einfache Raumobjekte wie Quader, Pyramide, Zylinder, Ellipsoid etc. sein. Die Eingabe eines Gestaltelementes erfolgt durch Auswählen des Typs eines einzugebenden Objekts wie etwa Gerade, Ellipse, etc. durch Auswählen aus einem von dem Prozessor am Bildschirm ausgegebenen Menü von Objekten und anschließendes Eingeben der Koordinaten bestimmter Punkte des ausgewählten Objektes.

Die Konstruktionstätigkeit wird jedoch erheblich vereinfacht und rationalisiert durch die Möglichkeit, zusammengesetzte Gestaltelemente zu definieren und beim Zeichnen einzusetzen. Ein zusammengesetztes Gestaltelement wird definiert, indem ein Benutzer eine Mehrzahl von Objekten, die elementar oder ihrerseits wiederum zusammengesetzt sein können, in den Arbeitsplatzrechner 01 eingibt oder unter bereits eingegebenen Objekten auswählt und dieser Gruppe einen Namen zuordnet, der anschließend in gleicher Weise wie die Namen der elementaren Objekte in einem Menü zum Zeichen vom System angezeigt wird und vom Benutzer auswählbar ist.

Fig. 2 zeigt ein Beispiel für einen Inhalt des Speichers 03 während eines Konstruktionsprozesses unter Verwendung von elementaren und zusammengesetzten Objekten. Jede Zeile des Diagramms von Fig. 2 entspricht dabei einem Gestaltelement. Jedes Gestaltelement setzt sich aus fünf Datenfeldern zusammen, die in Fig. 2 mit Buchstaben a bis e bezeichnet sind.

Das erste Datenfeld a jedes Gestaltelements hat das Format eines Zeigers auf einen Speicherplatz im Speicher 03. Wenn das Gestaltelement zusammengesetzt ist, enthält das Datenfeld a tatsächlich einen Zeiger auf diejenige Adresse im Speicher 03, an der sich das erste der Gestaltelemente befindet, aus denen das zusammengesetzte Objekt besteht. Wenn das Gestaltelement elementar ist, so kann das Datenfeld a einen Zeiger auf ein Unterprogramm zum Zeichnen des elementaren Objekts oder einen Zahlenwert enthalten, der keiner gültigen Adresse entspricht und für den Typ des Objekts repräsentativ ist.

Das zweite Datenfeld b jedes Gestaltelements enthält jeweils Angaben P, O, S über Position, Orientierung und Skalierung des Objekts, gegebenenfalls auch weitere Parameter wie Linienstärke, Linienmuster, etc..

Das dritte Datenfeld c enthält jeweils einen Zeiger auf ein Vorgänger-Gestaltelement. Im Falle des ersten Gestaltelements GE1 existiert kein solcher Vorgänger, und das Datenfeld c hat den Wert NULL; z. B. beim zweiten Gestaltelement GE2 ist es ein Zeiger auf GE1.

Das vierte Datenfeld d enthält jeweils einen Zeiger auf das nachfolgende Gestaltelement, im Falle von GE1 also einen Zeiger auf GE2.

Das fünfte Datenfeld e ist bei einem einfachen oder zusammengesetzten Gestaltelement ohne Funktion; seine Aufgabe wird an späterer Stelle erläutert.

Beim Beispiel der Fig. 2 ist angenommen, dass das Gestaltelement GE2 zusammengesetzt ist. Sein Datenfeld a enthält deshalb einen Zeiger *OB2 auf das erste Gestaltelement GE21 einer Gruppe von Gestaltelementen GE21 bis GE2N, die das Objekt OB2 bilden. Der Aufbau dieser Gruppe von Gestaltelementen ist der gleiche wie bei der Gruppe von Elementen GE1 bis GEN.

Das Gestaltelement GEi ist ebenfalls zusammengesetzt. Bei diesem Gestaltelement zeigt der Zeiger *OBi im Datenfeld a jedoch nicht auf das erste Gestaltelement GEi1 des Objekts OBi, sondern auf eine Datenstruktur, die hier als Verzweigungsstruktur bezeichnet wird und bei der die Typangabe im Datenfeld a den Wert *NULL hat. Dieser Wert kann bei einem Gestaltelement nicht vorkommen, er dient dem System als Unterscheidungsmerkmal zwischen Gestaltelementen und Verzweigungsstrukturen. Das zweite Datenfeld b der Verzweigungsstruktur ist ungenutzt; das dritte Datenfeld c enthält einen Zeiger *EOBi, und das vierte Datenfeld d einen Zeiger *GEi1. *GEi1 ist ein Zeiger auf das erste Gestaltelement GEi1 des Objekts OBi. *EOBi ist ein Zeiger auf ein sogenanntes Ersatzobjekt des Objekts OBi.

Bei der Berechnung einer graphischen Darstellung des Gestaltelements GEi wird der Wert des fünften Datenfeld e ausgewertet, das zwei verschiedene Werte E oder ¬E (Ersatz-Gestaltelement oder nicht Ersatz-Gestaltelement) annehmen kann. Wenn das Datenfeld e den Wert ¬E hat, so verwendet das System zum Zeichen des Objekts OBi den Zeiger *GEi1 im Datenfeld d und arbeitet so der Reihe nach die Gestaltelemente GEi1 bis GEiN des Objekts OBi ab, d. h. das Gestaltelement GEi wird mit allen Details der Gestaltelemente GEi1 bis GEiN, aus denen es zusammengesetzt ist, angezeigt.

Wenn das Datenfeld e der Verzweigungsstruktur GEi den Wert E hat, so wird anstelle des Objekts OBi dessen Ersatzobjekt EOBi gezeichnet, das beim vorliegenden Beispiel nur aus einem einzigen Gestaltelement EGEi1 besteht. Selbstverständlich könnte aber auch das Ersatzobjekt EOBi aus mehreren Gestaltelementen bestehen, die in analoger Weise wie oben beschrieben durch jeweils aufeinanderzeigende Zeiger in ihren Datenfeldern c, d verknüpft sind.

Die Verwendung der Ersatz-Gestaltelemente vereinfacht erheblich die Top-Down-Konstruktion eines komplexen Gegenstandes sowie das arbeitsteilige Konstruieren. Dies soll nun vereinfacht am Beispiel der Konstruktion einer Druckmaschine erläutert werden.

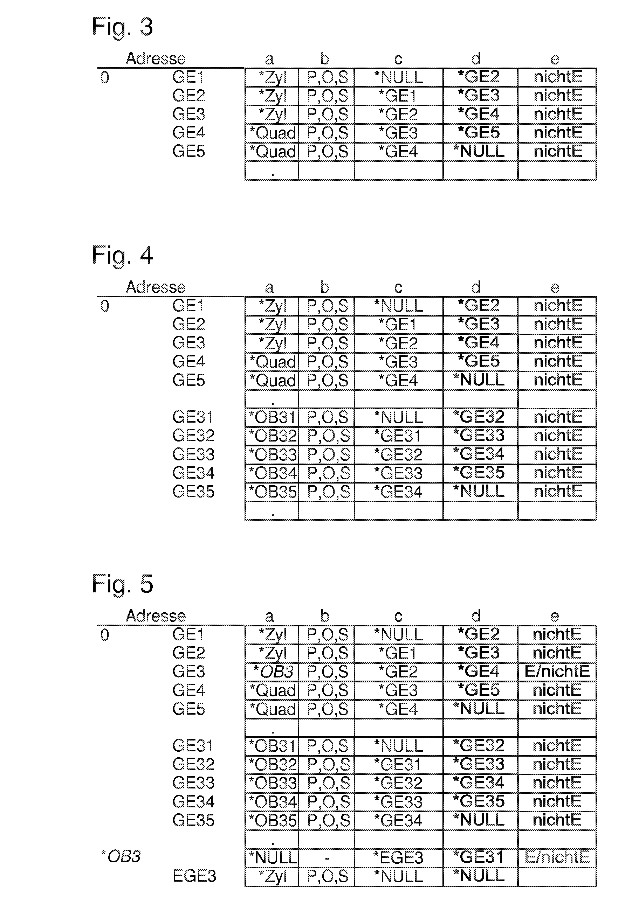

In einer sehr groben Vereinfachung kann man eine Druckmaschine ansehen als eine Anordnung einer Mehrzahl von Zylindern zwischen zwei seitlichen Gestellplatten. Eine erste Stufe des Konstruktionsvorgangs der Maschine kann daher darin bestehen, dass zunächst diese stark vereinfachten Elemente konstruiert, d. h. die entsprechenden Gestaltelemente in den Speicher 03 eingegeben werden. Es ergibt sich ein Speicherinhalt wie beispielhaft in Fig. 3 dargestellt, mit fünf Gestaltelementen GE1 bis GE5, darunter drei Zylinder, die jeweils eine Walze der Druckmaschine darstellen, und zwei quader- oder prismenförmigen Gestaltelementen für die Gestellplatten.

Die Datenfeld a jedes dieser Gestaltelemente enthalten folglich jeweils einen Adresswert *Zyl bzw. *Quad, der dem Unterprogramm zum Zeichnen eines Zylinders bzw. Quaders des CAD-Systems entspricht.

Um nun eine der Walzen im Detail zu konstruieren, gibt ein Konstrukteur in das System einen Befehl zum Schaffen einer neuen Gruppe ein. Im Anschluss daran legt das System vom Konstrukteur eingegebene Gestaltelemente GE31 bis GE35 der so geöffneten Gruppe in einem Bereich des Speichers 03 als miteinander durch Zeiger verknüpfte Datenstrukturen im gleichen Format wie die Gestaltelemente GE1 bis GE5 ab.

Nachdem der Benutzer einen Befehl zum Schließen der Gruppe eingegeben hat, gibt es unterschiedliche Möglichkeiten, die Gestaltelemente der Gruppe mit den Gestaltelementen GE1 bis GE5 zu verknüpfen.

Unter der Annahme, dass die Gruppe der Gestaltelemente GE31 bis GE35 das Gestaltelement GE3 ersetzen soll, ist eine erste, einfache nicht in einer Figur dargestellte Möglichkeit, die Zeiger *GE3 in den Gestaltelementen GE2 und GE4 durch *GE31 bzw. *GE35 zu ersetzen und die Null-Zeiger von GE31 und GE35 durch *GE2 bzw. *GE4 zu ersetzen. Dies entspricht in der graphischen Darstellung einer einfachen Ersetzung des Gestaltelements GE3 durch seine detailliertere Darstellung in Form der Gestaltelemente GE31 bis GE35.

Eine andere Möglichkeit ist, dass der Benutzer beim Schließen der Gruppe dieser einen Namen, z. B. "Objekt1", verleiht, und das System diesen Namen in ein Menü von auswählbaren, zu zeichnenden Gegenständen aufnimmt und ihm einen Zeiger *GE31 auf das erste Objekt der Gruppe zuordnet. Um die Gruppe GE31 bis GE35 dauerhaft anstelle des Gestaltelements GE3 in die graphische Darstellung des Konstruktionsgegenstandes einzubeziehen, genügt es, im Datenfeld a des Gestaltelements GE3 den Zeiger *Zyl durch *GE31 zu ersetzen. Diese Vorgehensweise erlaubt es, auch andere Gestaltelemente aus der Gruppe GE1 bis GE5 durch das aus GE31 bis GE35 zusammengesetzte Gestaltelement zu ersetzen, indem eine entsprechende Änderung des Zeigers im Datenfeld a dieser anderen Gestaltelemente vorgenommen wird.

Eine dritte Möglichkeit ist anhand der Fig. 5 veranschaulicht, die in analoger Weise wie die Fig. 2 bis 4 den Inhalt des Speichers 03 darstellt. Wenn der Benutzer das ursprüngliche Gestaltelement GE3 als Ersatz-Gestaltelement für die Gruppe GE31 bis GE35 definiert, so legt das System an einer Adresse *OB3 des Speichers eine Verzweigungs-Datenstruktur wie in Fig. 2 gezeigt an, deren Datenfeld d einen Zeiger auf GE31 enthält und deren Datenfeld c einen Zeiger auf ein ebenfalls neu angelegtes Gestaltelement EGE3 enthält. In die Datenfelder a, b des Gestaltelements EGE3 werden die entsprechenden Daten des ursprünglichen Gestaltelements GE3 kopiert; und das Datenfeld a von GE3 wird mit einem Zeiger *OB3 überschrieben.

Das Datenfeld e der Verzweigungs-Datenstruktur enthält die Angabe E/¬E, die spezifiziert, ob für das Gestaltelement GE3 die Gruppe GE31 bis GE35 von Gestaltelementen oder das Ersatz-Gestaltelement EGE3 gezeichnet werden soll. Diese Angabe ist durch einen Benutzer zu einem beliebigen Zeitpunkt des Konstruktionsvorgangs veränderbar. Dies erlaubt es dem Benutzer, jederzeit auszuwählen, ob er das Ersatz-Gestaltelement in einer graphischen Darstellung sehen möchte und so einen schnellen Bildaufbau erreicht, oder ob er eine detaillierte Darstellung benötigt, in der die gesamte Gruppe GE31 bis GE35 ausgewertet ist.

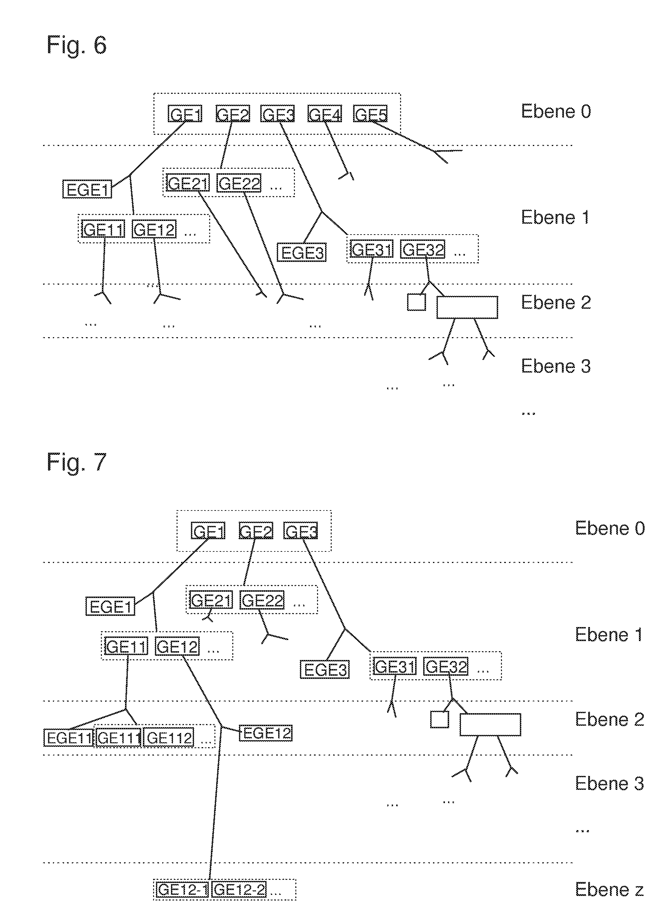

Selbstverständlich können in der gleichen Weise wie oben beschrieben auch Gestaltelemente der Gruppe GE31 bis GE35 zu Ersatz-Gestaltelementen für eine später definierte Gruppe gemacht werden. Man erhält so im Laufe des Konstruktionsvorgangs eine baumartige Struktur der Konstruktionsdaten, wie in Fig. 6 veranschaulicht. Eine Basisgruppe von Gestaltelementen, im betrachteten Beispiel die Gestaltelemente GE1 bis GE5 der drei Walzen und der Gestellplatten, bildet eine Wurzel des Baums in einer Ebene 0. Jedes Gestaltelement dieser Wurzel ist Ausgangspunkt eines Zweiges, der zu einem Ersatz-Gestaltelement EGE1 oder EGE3 sowie zu einer Gruppe von Gestaltelementen GE11, GE12, ..., bzw. GE31, GE32, ... oder auch nur zu einer Gruppe wie G21, G22, ... ohne zugeordnetes Ersatz-Gestaltelement einer nächsttieferen Ebene 1 führt, die für einzelne Baugruppen des durch GE1, GE3 bzw. GE2 dargestellten Teils des Konstruktionsgegenstandes stehen. Die Verästelung setzt sich über eine im Prinzip beliebige Zahl von Ebenen fort bis hin zu Gestaltelementen, die entweder elementar sind oder die in einer Bibliothek enthaltene Beschreibungen von Standardbauelementen darstellen.

Das Datenfeld e der oben beschriebenen Datenstrukturen erlaubt es, für jede Gruppe von Gestaltelementen, der ein Ersatz-Gestaltelement zugeordnet ist, durch Setzen der Angabe E/¬E einzeln festzulegen, ob die graphische Darstellung detailliert sein soll oder nur das jeweilige Ersatz-Gestaltelement zeigen soll.

Eine andere Möglichkeit, die Detailliertheit der graphischen Darstellung festzulegen, wird anhand von Fig. 7 erläutert. Die Wurzel der Baumstruktur auf der Ebene 0 enthält hier z. B. Gestaltelemente GE1, GE2, GE3. Auf einer nächsttieferen Ebene 1 ist dem Gestaltelement GE1 ein Ersatz-Gestaltelement EGE1 und eine Gruppe von Gestaltelementen GE11, GE12, ... zugeordnet, die wahlweise anstelle des Ersatz-Gestaltelements EGE1 darstellbar sind. Dem Gestaltelement GE11 entspricht wiederum auf der nächsttieferen Ebene 2 das Ersatz-Gestaltelement EGE11 und eine Gruppe von statt dessen darstellbaren Gestaltelementen GE111, GE112, ....

Das System bietet dem Benutzer eine Möglichkeit, eine hier als Auflösungsebene bezeichnete Ebene zu spezifizieren, bis zur der Ersatz-Gestaltelemente anstelle einer detaillierten Darstellung der graphischen Darstellung zugrundegelegt werden sollen. D. h., wenn der Benutzer als Auflösungsebene die Ebene 1 spezifiziert, wird die graphische Darstellung auf der Grundlage des Ersatz-Gestaltelements EGE1 sowie anderer auf dieser Ebene vorhandener Ersatz-Gestaltelemente erzeugt. Zum Darstellen der Gestaltelemente GE21, GE22, denen auf der Ebene 1 kein Ersatz-Gestaltelement entspricht, muss der Baum bis auf tiefere Ebenen verfolgt werden, wo, wenn vorhanden, die Berechnung der Darstellung mit der Berücksichtigung eines Ersatz-Gestaltelementes abgebrochen werden kann oder der Baum mit einem elementaren Gestaltelement endet.

Die Auswahl der Auflösungsebene ist für alle Gestaltelemente wirksam; daher wird im dargestellten Falle auch für GE3 das auf der als Auflösungsebene gewählten Ebene 1 vorhandene Ersatz-Gestaltelement EGE3 dargestellt.

Wenn ein Benutzer eine um eine Ebene detailliertere Darstellung wünscht und infolgedessen die Ebene 2 ab Auflösungsebene auswählt, so wird nicht EGE1 dargestellt, sondern die von diesem Ersatz-Gestaltelement vertretene Gruppe GE11, GE12 von Gestaltelementen wird in der Baumstruktur weiter verfolgt. So stößt das System z. B. für das Gestaltelement GE11 in der Ebene 2 auf ein Ersatz-Gestaltelement EGE11 und eine Gruppe von alternativ darstellbaren Gestaltelementen GE111, GE112, .... Für die graphische Darstellung berücksichtigt wird das Ersatz-Gestaltelement EGE11.

Für das Gestaltelement GE12 der Ebene 1 existiert auf der Ebene 2 nur ein Ersatz-Gestaltelement EGE12; eine Gruppe von durch dieses Ersatz-Gestaltelement vertretene Gestaltelementen GE12-1, GE12-2, ... ist auf einer tieferen Hierarchieebene z angesiedelt. Bei dieser Ebene 2 kann es sich im Prinzip um eine beliebige Ebene der Baumstruktur handeln, insbesondere aber um eine unterste Ebene, in der ausschließlich elementare Gestaltelemente bzw. Verweise auf Gestaltbeschreibungen von Standardbauelementen in einer Bibliothek angesiedelt sind. So lange als Auflösungsebene die Ebene 2 gewählt ist, wird hier, genauso wie beim von GE11 ausgehenden Ast, das auf der Ebene 2 angesiedelte Ersatz-Gestaltelement EGE12 dargestellt. Wenn der Benutzer jedoch eine nochmals um eine Ebene detailliertere Darstellung wählt, so verfolgt das System die von GE111, GE112 ausgehenden Zweige und überprüft, ob in der Ebene 3 jeweils für diese Elemente darstellbare Ersatz-Gestaltelemente vorhanden sind und stellt gegebenenfalls diese dar. Im Falle des von GE12 ausgehenden Zweiges ist jedoch die Ebene 3 leer. Es bleibt daher in diesem Fall bei der Darstellung des Ersatz-Gestaltelementes EGE12 der Ebene 2, auch wenn als Auflösungsebene die Ebene 3 gewählt ist.

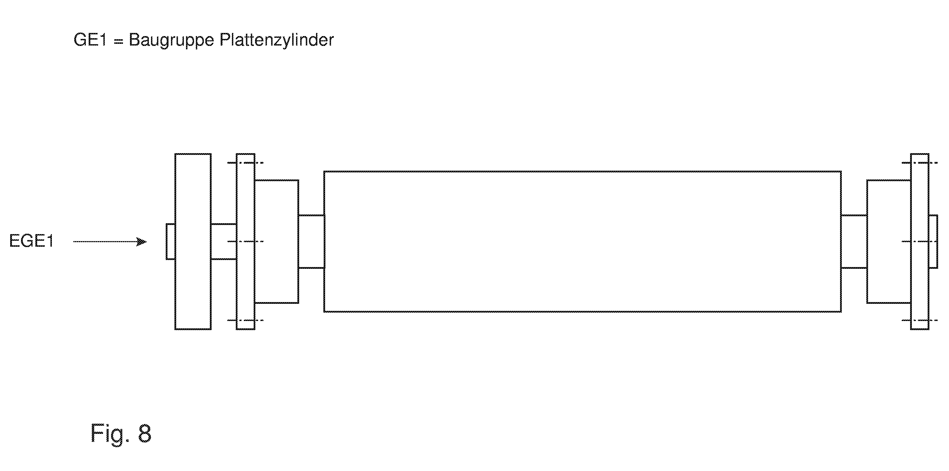

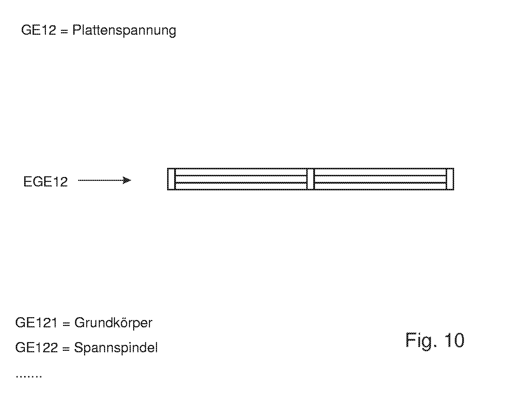

Ein erstes Ausführungsbeispiel zu der in der Fig. 7 gezeigten Datenstruktur ist in den Figuren 8 bis 10 dargestellt.

In Fig. 8 befindet sich in der Ebene 0 (Fig. 7) das Gestaltelement GE1, in welchem die Baugruppe Plattenzylinder abgespeichert ist.

Diesem werden jeweils eine erste Gruppe von internen Informationen zur Konstruktion des zu konstruierenden Gegenstandes selbst (= baugruppeninterne Informationen) und eine zweite Gruppe von externen Informationen zur An-/Einbindung des späteren konstruierten Gegenstandes oder des vorliegenden Ersatz-Gestaltelementes (EGE1) an benachbarte Gegenstände (= Schnittstelleninformatonen zu benachbarten Teilen) zugeordnet.

Baugruppeninterne Informationen können z. B. Angaben zu Zahnradabmessungen und/oder Angaben zu Position und Abmessung der Lagerstellen sein. Schnittstelleninformationen zu benachbarten Teilen können z. B. Angaben über den benötigten Bauraum, der Lagerbüchsendurchmesser oder eine Bohrbildinformation für beide Seitenwände sein.

Danach wird dieses Bauteil als Ersatz-Gestaltelement (EGE1) abgespeichert.

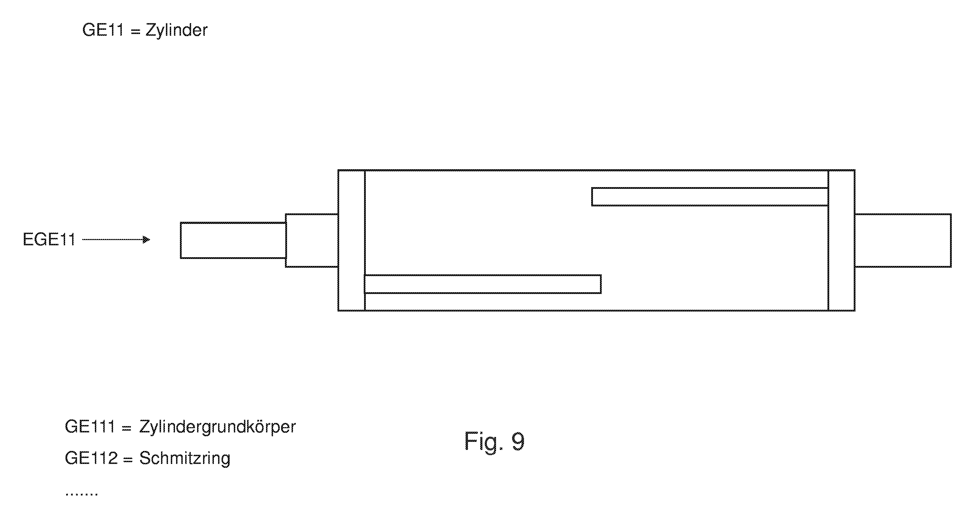

Jetzt ist schon für andere Konstrukteure ein Zugriff auf dieses Element, das wesentliche Informationen für die Konstruktion anderer Bauteile bzw. Aggregate enthält, möglich. Wie die Fig. 9 zeigt, kann nun der Zylinder, der als Grundelement GE11 bezeichnet wird und in der Ebene 1 liegt, weiter bearbeitet werden, um z. B. Kanäle im Zylinder festzulegen. Als Schnittstelleninformationen zu benachbarten Teilen werden hier z. B. Angaben über den benötigten Bauraum, zur Lage und Abmessung der Kanäle oder der Zapfendurchmesser an der Lagerstelle abgelegt. Als baugruppeninterne Informationen kommen z. B: der Durchmesser und die Breite der Schmitzringe oder die Zylinderballenlänge in Betracht.

Dieses Bauteil mit den neuen internen bzw. externen Informationen wird nun in der Ebene 2 (Fig. 7) als Ersatz-Gestaltelement EGE11 abgelegt, so dass auch hier Informationen von allen Anwendern des Programmes abgerufen werden können.

Anschließend können dann die Gestaltelemente GE111 = Zylindergrundkörper oder GE112 = Schmitzring zur Weiterverarbeitung anstehen.

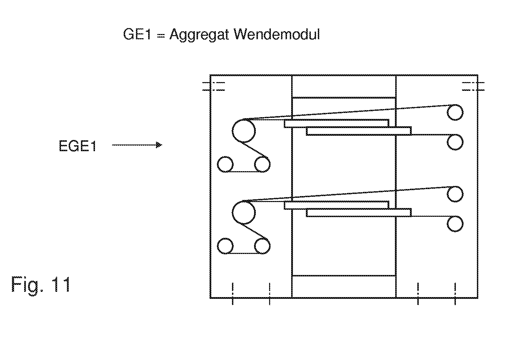

Ein zweites Ausführungsbeispiel ist in den Figuren 11 bis 13 dargestellt. Wie die Fig. 11 zeigt, steht in der Ebene 0 als Gestaltelement GE1 ein Wendemodulaggregat zur Auswahl. Als Schnittstelleninformationen zu benachbarten Teilen können hier z. B. der benötigte Bauraum, die lichte Weite oder Anbindungsmöglichkeiten festgelegt werden. Als aggregatinterne Informationen werden z. B. die Lage und Durchmesser der Walzen und/oder die Form der Seitenwände festgelegt. Nach Abarbeitung der internen und externen Informationen wird nun das Bauteil als Ersatz-Gestaltelement EGE1 abgespeichert.

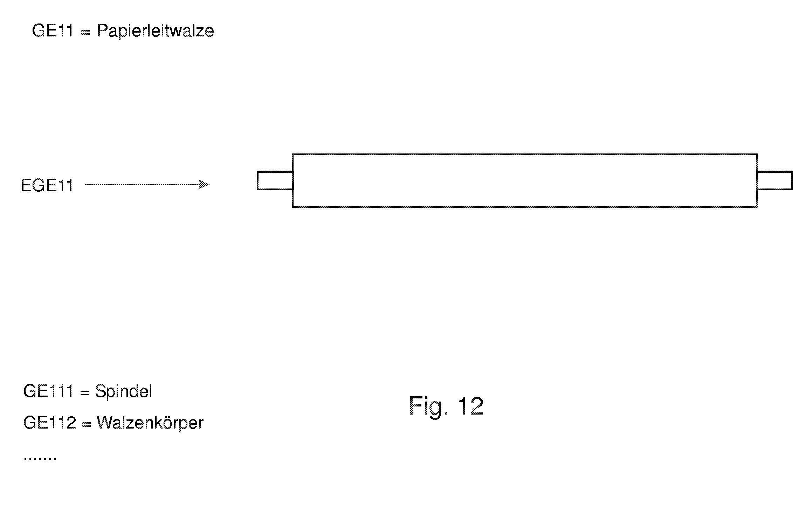

Anschließend kann das Gestaltelement 11, welches in Fig. 12 als Papierleitwalze dargestellt ist, bearbeitet werden. Als Schnittstelleninformationen zu benachbarten Teilen können hier z. B. der benötigte Bauraum und/oder der Durchmesser und die Länge der Walze sein. Als baugruppeninterne Informationen können z. B. die Abmessungen und/oder die Lagerstellen abgespeichert werden.

Anschließend wird die so konstruierte Papierleitwalze als Eratz-Gestaltelement EGE1 abgespeichert. In der nächst tieferen Ebene können dann z. B. als Gestaltelemente Spindel bzw. Walzenkörper als Gestaltelemente G111 bzw. G112 abgelegt sein.

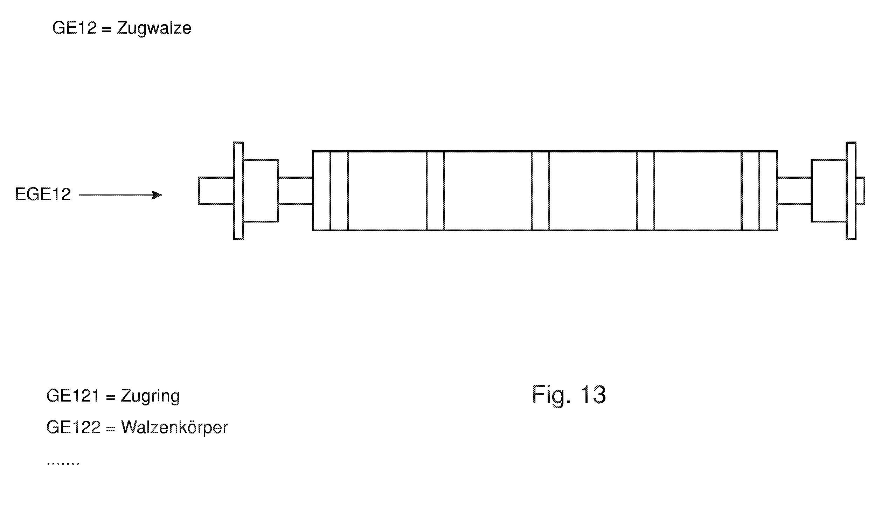

Gemäß Fig. 7 liegt das in der Figur 13 dargestellte Gestaltelement GE12, welches hier als Zugwalze dargestellt ist, in der gleichen Ebene wie das Gestaltelement GE11.

Dieser Zugwalze werden nun Schnittstelleninformationen zu benachbarten Teilen wie z. B benötigter Bauraum, Durchmesser und Länge der Walze oder Durchmesser der Lagerung zugeordnet. Angaben zu baugruppeninterne Informationen können z. B. Angaben zur Lage und dem Durchmesser der Zugringe oder zur Zapfenabmessung sein.

Auch dieses Bauteil wird als Ersatz-Gestaltelement EGE12 abgespeichert.

Anzumerken ist noch, das die Ersatz-Gestaltelemente EGEi jeweils nur einen Teil (Grundinformationen) der Geometrieinformationen des später konstruierten detaillierten Gegenstandes haben.

Die Zuweisung von Gestaltelementen oder von Gruppen von Gestaltelementen zu einer bestimmten Ebene der Baumstruktur kann willkürlich vom Benutzer vorgenommen werden, oder sie kann auch nach vorgegebenen Regeln durch das CAD-System selbst erfolgen. So kann z. B. vorgesehen werden, dass sämtliche Gestaltelemente, die elementar sind oder aus einer Bibliothek entnommenen Standard-Konstruktionsteilen entsprechen, in einer untersten Ebene der Baumstruktur angesiedelt werden, so dass sie nur dann in der graphischen Darstellung detailliert erscheinen, wenn entweder ein Benutzer eine Darstellung mit maximalem Detailreichtum auswählt, oder wenn diese Gestaltelemente der untersten Ebene zu keiner Gruppe gehören, der auf einer höheren Ebene ein Ersatz-Gestaltelement zugeordnet ist.

Kein Ersatz-Gestaltelement auf einer höheren Ebene zuzuordnen, kann insbesondere für solche elementaren oder Bibliotheks-Gestaltelemente sinnvoll sein, die für die Verbindung von Baugruppen untereinander wichtig sind und deshalb für alle mit dem Konstruieren dieser Baugruppen befassten Benutzer jederzeit sichtbar sein sollten.

Bei der Baumstruktur der Fig. 7 sind Ersatz-Gestaltelemente wie EGE1, EGE3 und die ihnen zugeordneten Gruppen GE11, GE12, ... bzw. GE31, GE32, ... jeweils auf der gleichen Ebene 1 der Baustruktur angeordnet. Dabei handelt es sich aber um nichts weiter als eine logische Konvention. Die gleiche Arbeitsweise des CAD-Systems ließe sich auch realisieren, wenn die Ersatz-Gestaltelemente sämtlich um jeweils eine Ebene höher als die zugeordneten Gruppen in der Baustruktur angesiedelt wären.

Wenn die Auswahl einer Auflösungsebene als Alternative zur Verwendung des Datenfeldes e zum Festlegen des Detailreichtums der graphischen Darstellung eingesetzt wird, so kann das Datenfeld e in den Datenstrukturen der einzelnen Gestaltelemente entfallen. Es können aber auch beide Verfahren in Kombination eingesetzt werden, wobei festgelegt werden muss, welcher der zwei Ansätze Vorrang vor dem anderen hat. Zweckmäßig ist insbesondere, der Angabe E/¬E Vorrang vor der gewählten Auflösungsebene einzuräumen: Wenn in einer Verzweigungsstruktur eines Objektes im Datenfeld e der Wert ¬E von einem Benutzer gesetzt ist, ist die Darstellung des Objekts durch sein Ersatz-Gestaltelement verboten und es muss unabhängig von der gewählten Auflösungsebene detailliert angezeigt werden. Hat das Datenfeld e hingegen den Wert E, so ist die Darstellung des Objekts durch sein Ersatz-Gestaltelement erlaubt, und ob tatsächlich das Ersatz-Gestaltelement dargestellt wird, richtet sich nach der gewählten Auflösungsebene. Befindet sich das Ersatz-Gestaltelement auf der gewählten Auflösungsebene, so wird es dargestellt; befindet es sich darüber, wird statt dessen die Baumstruktur auf die nächsttiefere Ebene weiterverfolgt.

In einem CAD-System mit mehreren Arbeitsplätzen 01, an denen mehrere Konstrukteure auf gleiche Daten (Gestaltelemente) eines zu konstruierenden komplexen Gegenstandes zugreifen müssen, umfasst das Datenfeld e jeder Verzweigungsstruktur zweckmäßigerweise mehrere Bits, von denen jedes einem Arbeitsplatz zugeordnet ist, so dass alle Arbeitsplätze unabhängig voneinander lesend auf einen einzigen Satz von Daten zugreifen können und dennoch für jeden Arbeitsplatz unabhängig von den anderen zwischen detaillierter Darstellung und Darstellung eines Ersatz-Gestaltelements umgeschaltet werden kann.

Dies ermöglicht es jedem an einem der Arbeitsplatzrechner 01 tätigen Konstrukteur, ausgehend von der für alle einheitlichen Gestaltbeschreibung im Speicher 03 eine Darstellung auf seinem Bildschirm 07 passend für seine Bedürfnisse einzustellen, in der die für ihn relevanten Baugruppen detailliert dargestellt sind, während von für ihn weniger wichtigen Baugruppen die Ersatz-Gestaltelemente zu sehen sind. Fig. 1 veranschaulicht dies anhand der vergrößerten Darstellungen 08; 09; 11 der Bildschirme 07. Während in der Vergrößerung 08 drei Walzen der Druckmaschine durch Ersatz-Gestaltelemente in Form einfacher Zylinder dargestellt sind, zeigen die Vergrößerungen 09; 11 jeweils eine dieser Walzen dem für sie zuständigen Konstrukteur detailliert.

Insbesondere bei einem solchen Mehrplatz-CAD-System kann es zweckmäßig sein, wenn das Datenfeld a eines zusammengesetzten Gestaltelements nicht nur einen Zeiger auf eine Adresse des Speichers 03 enthalten kann, an der die Beschreibung des zusammengesetzten Gestaltelements beginnt, sondern alternativ auch die Bezeichnung einer Datei entsprechenden Inhalts. Dies erleichtert unter Ausnutzung der Funktionen eines dem CAD-System zugrundeliegenden Betriebssystems, die Zugriffsberechtigung der einzelnen Arbeitsplätze auf die Beschreibungen zu kontrollieren. Wenn jeweils nur demjenigen Arbeitsplatz eine Berechtigung zum Schreiben in eine Datei eingeräumt ist, der mit der Konstruktion des in der Datei beschriebenen Bauteils des Konstruktionsgegenstandes beauftragt ist, kann der Inhalt dieser Datei zwar an allen Arbeitsplätzen des Systems gelesen und bei der Konstruktion der dort zu konstruierenden Bauteile berücksichtigt werden, Änderungen an der Konstruktion des in der Datei beschriebenen Bauteils können hingegen nur von dem damit beauftragten Mitarbeiter am entsprechenden Arbeitsplatz vorgenommen werden.

Es liegt auf der Hand, dass die oben beschriebenen Datenstrukturen nur ein Beispiel unter vielen sind, mit denen das wesentliche Ziel der Erfindung erreichbar ist, nämlich zu beliebigen Zeitpunkten in einem Konstruktionsprozess für beliebige Baugruppen des Konstruktionsgegenstandes festlegen zu können, mit welchem Grad an Details diese dargestellt werden sollen. Während beim oben beschriebenen Beispiel Gestaltelemente und Verzeigungsstrukturen jeweils als zusammenhängende Datenstrukturen in einem gemeinsamen Speicher 03 abgelegt werden, kann es z. B. sinnvoll sein, dass das CAD-System die Datenfeld e der Verzweigungsstrukturen in Form von der übrigen Gestaltbeschreibung getrennten Dateien verwaltet, um so leichter gewährleisten zu können, dass an jedem Arbeitsplatzrechner 01 die diesem zugeordneten Datenfeld e gelesen und geschrieben werden können, während andere Teile der Verzweigungsstruktur nur von dem Arbeitsplatzrechner aus geschrieben werden dürfen, an dem das Bauteil konstruiert wird, zu dem die Verzweigungsstruktur gehört.

Im nachfolgenden wird ein Verfahren zum Konstruieren einer aus mehreren Baugruppen zusammengesetzte Maschine beschrieben: Für mindestens einen zu konstruierenden Gegenstand wird zuerst ein den zu konstruierenden Gegenstand vereinfacht darstellendes Ersatz-Gestaltelement (EGEi) festgelegt, diesem Ersatz-Gestaltelement (EGEi) werden Informationen über die Geometrie des zu konstruierenden Gegenstandes zugeordnet, mittels des Ersatz-Gestaltelementes (EGEi) und/oder seinen zugeordneten Informationen wird ein näher detaillierter Gegenstand konstruiert.

Dem Ersatz-Gestaltelement (EGEi) wird also mindestens eine Information über die Geometrie zu benachbarten Gegenständen, z. B. Anschlußmaße, zugeordnet. Wodurch beispielsweise der benötigte Bauraum zugeordnet werden kann. Desweiteren kann der Information mindestens ein Durchmesserwert zugeordnet werden, vorzugsweise aber zwei Durchmesserwerte.

Dem Ersatz-Gestaltelement (EGEi) werden jeweils eine erste Gruppe von internen Informationen zur Konstruktion des zu konstruierenden Gegenstandes selbst und eine zweite Gruppe von externen Informationen zur An-/Einbindung des späteren konstruierten Gegenstandes oder des vorliegenden Ersatz-Gestaltelementes (EGEi) an benachbarte Gegenstände zugeordnet.

Desweiteren kann in das Ersatz-Gestaltelement (EGEi) mindestens ein weiteres Ersatz-Gestaltelement (EGEi) eingefügt werden.

Als Darstellung kann das Ersatz-Gestaltelement (EGEi) dreidimensional dargestellt werden.

Das Ersatz-Gestaltelement (EGEi) kann als Rotationskörper festgelegt werden, wobei dem Ersatz-Gestaltelement (EGEi) mindestens ein Durchmesserwert zugeordnet werden kann. Mittels des Durchmesserwertes kann zumindest teilweise ein Ballen des Rotationskörper konstruiert werden. Mit einem zweiten Durchmesserwert, der dem Ersatz-Gestaltelement (EGEi) zugeordnet werden kann, ist es möglich, z. B. einen Zapfen und/oder eine Lagerstelle des Rotationskörpers zu konstruieren. Desweiteren kann dem Rotationskörper mindestens eine Länge zugeordnet werden sowie Position und Abmessung mindestens einer Lagerstelle.

Mittels des zweiten Durchmesserwerte kann eine Lagerung zwischen Ersatz-Gestaltelement (EGEi) und benachbartem Gegenstand beschrieben werden.

Mittels des Ersatz-Gestaltelementes (EGEi) kann eine Druckmaschine konstruiert werden.

Mittels des Ersatz-Gestaltelementes (EGEi) kann mindestens ein Aggregat, mindestens eine Druckeinheit, mindestens ein Wendemodul, mindestens ein Rollenwechsler, mindestens ein Falzapparat, mindestens ein Rollenlager, mindestens ein Modul eines Rollenlagers, mindestens ein Rollentransportfahrzeug, mindestens ein Lagerelement einer Druckmaschine, ein Schienenelement zur Führung eines Rollentransportfahrzeuges, eine Bearbeitungsstation für Materialrollen, eine Maschine zur Weiterverarbeitung von Druckprodukten, insbesondere gefalzten Druckprodukten, mindestens ein Greiferelement zur Aufnahme von Druckprodukten oder ein Modul einer Maschine zur Weiterverarbeitung von Druckprodukten dargestellt werden.

Mittels des Ersatz-Gestaltelementes (EGEi) kann eine Druckeinheit und innerhalb diesem Ersatz-Gestaltelementes (EGEi) der Druckeinheit wird mittels einer Mehrzahl von Ersatz-Gestaltelementes (EGEi) jeweils ein Druckzylinder oder eine Farbwalze dargestellt werden.

Wahlweise kann der detaillierte Gegenstand oder sein zugeordnetes
Ersatz-Gestaltelement (EGEi) dargestellt werden.

Auch ist es denkbar, die Informationen mehrerer Ersatz-Gestaltelemente (EGEi) zu verknüpfen.

Bezugszeichenliste
- 01: Arbeitsplatzrechner
- 02: Netz-Datenleitung
- 03: Eingabegerät, Speicher
- 04: Eingabegerät, Maus
- 05: -
- 06: Digitalisiertablett
- 07: Anzeigeeinrichtung, Bildschirm
- 08: Vergrößerung
- 09: Vergrößerung
- 10: -
- 11: Vergrößerung

## Patentansprüche

1. Verfahren zum Konstruieren einer aus mehreren Baugruppen zusammengesetzten Maschine mit folgenden Merkmalen:
- für mindestens einen zu konstruierenden Gegenstand wird zuerst ein den zu konstruierenden Gegenstand vereinfacht darstellendes Ersatz-Gestaltelement (EGEi) festgelegt,
- diesem Ersatz-Gestaltelement (EGEi) werden Informationen über die Geometrie des zu konstruierenden Gegenstandes zugeordnet,
- mittels des Ersatz-Gestaltelementes (EGEi) und/oder seinen zugeordneten Informationen wird ein näher detaillierter Gegenstand konstruiert.

2. Verfahren nach Anspruch 1, **dadurch gekennzeichnet, dass** dem
Ersatz-Gestaltelement (EGEi) mindestens eine Information über die Geometrie zu benachbarten Gegenständen zugeordnet wird.

3. Verfahren nach Anspruch 1, **dadurch gekennzeichnet, dass** dem
Ersatz-Gestaltelement (EGEi) jeweils eine erste Gruppe von internen Informationen zur Konstruktion des zu konstruierenden Gegenstandes selbst und eine zweite Gruppe von externen Informationen zur An-/Einbindung des späteren konstruierten Gegenstandes oder des vorliegenden Ersatz-Gestaltelementes (EGEi) an benachbarte Gegenstände zugeordnet wird.

4. Verfahren nach Anspruch 1, **dadurch gekennzeichnet, dass** in das
Ersatz-Gestaltelement (EGEi) mindestens ein weiteres Ersatz-Gestaltelement (EGEi) eingefügt wird.

5. Verfahren nach Anspruch 1, **dadurch gekennzeichnet, dass** das
Ersatz-Gestaltelement (EGEi) als Ersatzkörper dreidimensional dargestellt wird.

6. Verfahren nach Anspruch 1 oder 2, **dadurch gekennzeichnet, dass** das
Ersatz-Gestaltelement (EGEi) als Rotationskörper festgelegt wird.

7. Verfahren nach Anspruch 1, **dadurch gekennzeichnet, dass** dem
Ersatz-Gestaltelement (EGEi) mindestens ein Durchmesserwert zugeordnet wird.

8. Verfahren nach Anspruch 7, **dadurch gekennzeichnet, dass** mittels des Durchmesserwertes ein Ballen des Rotationskörpers konstruiert wird.

9. Verfahren nach Anspruch 7, **dadurch gekennzeichnet, dass** dem
Ersatz-Gestaltelement (EGEi) mindestens ein zweiter Durchmesserwert zugeordnet wird.

10. Verfahren nach Anspruch 6 und 9, **dadurch gekennzeichnet, dass** mittels des zweiten Durchmesserwertes ein Zapfen des Rotationskörpers konstruiert wird.

11. Verfahren nach Anspruch 6, **dadurch gekennzeichnet, dass** dem Rotationskörper mindestens eine Länge zugeordnet wird.

12. Verfahren nach Anspruch 6, **dadurch gekennzeichnet, dass** dem Rotationskörper Position und Abmessung mindestens einer Lagerstelle zugeordnet wird.

13. Verfahren nach Anspruch 2, **dadurch gekennzeichnet, dass** der Information der benötigte Bauraum zugeordnet wird.

14. Verfahren nach Anspruch 2 und 6, **dadurch gekennzeichnet, dass** der Information mindestens ein Durchmesserwert zugeordnet wird.

15. Verfahren nach Anspruch 14, **dadurch gekennzeichnet, dass** mittels des Durchmesserwertes zumindest teilweise ein Ballen des Rotationskörpers beschrieben wird.

16. Verfahren nach Anspruch 14, **dadurch gekennzeichnet, dass** der Information mindestens ein zweiter Durchmesserwert zugeordnet wird.

17. Verfahren nach Anspruch 16, **dadurch gekennzeichnet, dass** mittels des zweiten Durchmesserwertes eine Lagerung zwischen Ersatz-Gestaltelement (EGEi) und benachbartem Gegenstand beschrieben wird.

18. Verfahren nach Anspruch 1, **dadurch gekennzeichnet, dass** mittels des Ersatz-Gestaltelementes (EGEi) eine Druckmaschine konstruiert wird.

19. Verfahren nach Anspruch 1, **dadurch gekennzeichnet, dass** mittels des Ersatz-Gestaltelementes (EGEi) mindestens ein Aggregat einer Druckmaschine dargestellt wird.

20. Verfahren nach Anspruch 19, **dadurch gekennzeichnet, dass** mittels des Ersatz-Gestaltelementes (EGEi) mindestens eine Druckeinheit dargestellt wird.

21. Verfahren nach Anspruch 19, **dadurch gekennzeichnet, dass** mittels des Ersatz-Gestaltelementes (EGEi) mindestens ein Wendemodul dargestellt wird.

22. Verfahren nach Anspruch 1 oder 19, **dadurch gekennzeichnet, dass** mittels des Ersatz-Gestaltelementes (EGEi) mindestens ein Rollenwechsler dargestellt wird.

23. Verfahren nach Anspruch 19, **dadurch gekennzeichnet, dass** mittels des Ersatz-Gestaltelementes (EGEi) mindestens ein Falzapparat dargestellt wird.

24. Verfahren nach Anspruch 1, **dadurch gekennzeichnet, dass** mittels des
Ersatz-Gestaltelementes (EGEi) ein Rollenlager für eine Druckmaschine konstruiert wird.

25. Verfahren nach Anspruch 1, **dadurch gekennzeichnet, dass** mittels des
Ersatz-Gestaltelementes (EGEi) mindestens ein Modul eines Rollenlagers dargestellt wird.

26. Verfahren nach Anspruch 25, **dadurch gekennzeichnet, dass** mittels des Ersatz-Gestaltelementes (EGEi) mindestens ein Rollentransportfahrzeug dargestellt wird.

27. Verfahren nach Anspruch 24, **dadurch gekennzeichnet, dass** mittels des Ersatz-Gestaltelementes (EGEi) mindestens ein Lagerelement zur Aufnahme von Materialrollen dargestellt wird.

28. Verfahren nach Anspruch 25, **dadurch gekennzeichnet, dass** mittels des Ersatz-Gestaltelementes (EGEi) ein Schienenelement zur Führung eines Rollentransportfahrzeuges dargestellt wird.

29. Verfahren nach Anspruch 26, **dadurch gekennzeichnet, dass** mittels des Ersatz-Gestaltelementes (EGEi) eine Bearbeitungsstation für Materialrollen dargestellt wird.

30. Verfahren nach Anspruch 1, **dadurch gekennzeichnet, dass** mittels des
Ersatz-Gestaltelementes (EGEi) eine Maschine zur Weiterverarbeitung von Druckprodukten, insbesondere gefalzten Druckprodukten, konstruiert wird.

31. Verfahren nach Anspruch 29, **dadurch gekennzeichnet, dass** mittels eines Ersatz-Gestaltelementes (EGEi) mindestens ein Greiferelement zur Aufnahme von Druckprodukten dargestellt wird.

32. Verfahren nach Anspruch 1, **dadurch gekennzeichnet, dass** mittels des
Ersatz-Gestaltelementes (EGEi) ein Modul einer Maschine zur Weiterverarbeitung von Druckprodukten dargestellt wird.

33. Verfahren nach Anspruch 17, **dadurch gekennzeichnet, dass** mittels des Ersatz-Gestaltelementes (EGEi) eine Druckeinheit und innerhalb diesem Ersatz-Gestaltelementes (EGEi) der Druckeinheit mittels einer Mehrzahl von Ersatz-Gestaltelementes (EGEi) jeweils ein Druckzylinder oder eine Farbwalze dargestellt wird.

34. Verfahren nach Anspruch 1, **dadurch gekennzeichnet, dass** wahlweise der detaillierte Gegenstand oder sein zugeordnetes Ersatz-Gestaltelement (EGEi) dargestellt wird.

35. Verfahren nach Anspruch 2, **dadurch gekennzeichnet, dass** die Informationen mehrerer Ersatz-Gestaltelemente (EGEi) verknüpft werden.

36. CAD-System zum Unterstützen des Konstruierens eines komplexen Gegenstandes, insbesondere einer aus mehreren Baugruppen zusammengesetzten Maschine, mit: wenigstens einem Eingabegerät (04, 06) zum Eingeben einer Gestaltbeschreibung des Gegenstandes, wobei die Gestaltbeschreibung eine Vielzahl von Gestaltelementen (GE1, GE2, ... GEi, GEN...) umfasst,
wenigstens einem Prozessor zum Errechnen einer graphischen Darstellung des Gegenstandes aus der Gestaltbeschreibung des Gegenstands,
einem Programm zum Steuern des Betriebs des Prozessors, und
wenigstens einer Anzeigeeinrichtung (07) zum Anzeigen einer von dem Prozessor errechneten Darstellung des Gegenstandes,
**dadurch gekennzeichnet, dass** der Prozessor durch das Programm eingerichtet ist, die Gestaltelemente der Gestaltbeschreibung einer Mehrzahl von Gruppen (OB2, OBi) zuzuordnen, wenigstens einer dieser Gruppen (OBi) ein Ersatz-Gestaltelement (EGEi1) zuzuweisen, und beim Errechnen der Darstellung für wenigstens eine dieser Gruppen (OBi) wahlweise die Gesamtheit der der Gruppe (OBi) zugeordneten Gestaltelemente (GEi1, ..., GEiN) oder das der Gruppe zugewiesene Ersatz-Gestaltelement (EGEi1) zu berücksichtigen.

37. CAD-System nach Anspruch 36, **dadurch gekennzeichnet, dass** der Prozessor durch das Programm eingerichtet ist, die Zuordnung von Gestaltelementen (GEi1, ..., GEiN) zu einer Gruppe (OBi) nach Vorgabe durch einen Benutzer vorzunehmen.

38. CAD-System nach Anspruch 37, **dadurch gekennzeichnet, dass** der Prozessor durch das Programm eingerichtet ist, jedes bereits eingegebene Gestaltelement nachträglich einer Gruppe zuzuordnen.

39. CAD-System nach Anspruch 37 oder 38, **dadurch gekennzeichnet, dass** der Prozessor durch das Programm eingerichtet ist, nach der Vorgabe eines Benutzers eine Gruppe von Gestaltelementen zu öffnen und die während des Geöffnetseins einer Gruppe eingegebenen Gestaltelemente der Gruppe zuzuordnen.

40. CAD-System nach einem der Ansprüche 36 bis 39, **dadurch gekennzeichnet, dass** der Prozessor durch das Programm eingerichtet ist, die Zuweisung eines Ersatz-Gestaltelements (EGE1) zu einer Gruppe (OBi) nach Vorgabe durch einen Benutzer vorzunehmen.

41. CAD-System nach Anspruch 40, **dadurch gekennzeichnet, dass** der Prozessor durch das Programm eingerichtet ist, jeweils bei der Eingabe eines Ersatz-Gestaltelements und/oder der Eingabe einer Erklärung eines bereits eingegebenen Gestaltelements zu einem Ersatz-Gestaltelement eine dem Ersatz-Gestaltelement zugeordnete Gruppe zu erzeugen.

42. CAD-System nach einem der Ansprüche 36 bis 41, **dadurch gekennzeichnet, dass** die Gestaltbeschreibung jedes Gegenstandes eine Menge von Gestaltbeschreibungen von Gestaltelementen und/oder von anderen Gegenständen umfasst, die Teile des erstgenannten Gegenstandes sind.

43. CAD-System nach einem der Ansprüche 36 bis 42, **dadurch gekennzeichnet, dass** es eine Mehrzahl von jeweils wenigstens ein Eingabegerät (04; 06) und eine Anzeigeeinrichtung (07) umfassenden Arbeitsplatzrechner (01) aufweist, wobei wenigstens einer der Arbeitsplatzrechner (01) einer der Gruppen derart zugeordnet ist, dass an diesem Arbeitsplatz das Hinzufügen, Verändern oder Entfernen von Gestaltelementen der Gruppe möglich ist, während dies an einem nicht dieser Gruppe zugeordneten Arbeitsplatz nicht möglich ist.

44. Verfahren zum Unterstützen des Konstruierens eines komplexen Gegenstands mit einem CAD-System, insbesondere nach einem der Ansprüche 36 bis 44, mit den Schritten:
a) Empfangen der Eingabe von Gestaltelementen des Gegenstands in das CAD-System, wobei eine Mehrzahl der eingegebenen Gestaltelemente eine Gruppe bildet, und eines der eingegebenen Gestaltelemente ein Ersatz-Gestaltelement der Gruppe ist;
b) Festlegen, ob beim Errechnen einer Darstellung des Gegenstands das Ersatz-Gestaltelement oder die Gesamtheit der Gestaltelemente der Gruppe zugrundegelegt werden soll;
c) Errechnen einer Darstellung des Gegenstands gemäß der Festlegung und Anzeigen der Darstellung.

45. Verfahren nach Anspruch 44, **dadurch gekennzeichnet, dass** Schritt a) die Schritte des Empfangens eines Befehls zum Öffnen einer Gruppe und eines Befehls zum Schließen der Gruppe umfasst, und dass zwischen dem Empfang des Befehls zum Öffnen der Gruppe und dem Befehl zum Schließen der Gruppe empfangene Gestaltelemente der Gruppe zugeordnet werden.

46. Verfahren nach Anspruch 44, **dadurch gekennzeichnet, dass** Schritt a) die Schritte des Empfangens einer Auswahl von bereits zuvor eingegebenen Gestaltelementen und eines Befehls zum Zusammenfassen der ausgewählten Gestaltelemente zu einer Gruppe umfasst.

47. Verfahren nach einem der Ansprüche 44, 45 oder 46, **dadurch gekennzeichnet, dass** Schritt a) ferner den Schritt des Zuordnens der Gruppe zu einem bereits eingegebenen Gestaltelement umfasst, das durch die Zuordnung zum Ersatz-Gestaltelement für die Gruppe wird.

48. Verfahren nach einem der Ansprüche 44 bis 47, **dadurch gekennzeichnet, dass** der komplexe Gegenstand eine Mehrzahl von Baugruppen umfassende komplexe Maschine ist, dass eine Gruppe von Gestaltelementen jeweils eine Beschreibung einer der Baugruppen darstellt und dass das der Gruppe von Gestaltelementen zugeordnete Ersatz-Gestaltelement die körperliche Gestalt der Baugruppe approximiert.

49. Verfahren für ein CAD-System, insbesondere nach einem der Ansprüche 36 bis 43, zum Unterstützen des Konstruierens einer eine Mehrzahl von Baugruppen umfassenden Maschine, mit den Schritten:
a) Empfangen der Eingabe eines Gestaltelements, das die Gestalt einer der Baugruppen approximiert, in das CAD-System,
b) Empfangen der Eingabe einer Gruppe von Gestaltelementen, die Details der Baugruppe spezifizieren, in das CAD-System,
c) Zuordnen des die Gestalt der Baugruppe approximierenden Gestaltelements zu der Gruppe als ein Ersatz-Gestaltelement für diese;
d) Festlegen, ob beim Errechnen einer Darstellung des Gegenstands die Gruppe von Gestaltelementen oder das Ersatz-Gestaltelement der Gruppe zugrundegelegt werden soll;
e) Errechnen einer Darstellung des Gegenstands gemäß der Festlegung und Anzeigen der Darstellung.
